# EUROPEAN PATENT SPECIFICATION

(11) **EP 2 881 785 B1**
(45) Date of publication and mention of the grant of the patent: **29.08.2018**
(21) Application number: 13863698.0
(22) Date of filing: 28.11.2013
(51) Int. Cl.: G02F 1/1362

(54) **ARRAY SUBSTRATE, MANUFACTURING METHOD THEREFOR, AND DISPLAY APPARATUS**
ARRAYSUBSTRAT UND HERSTELLUNGSVERFAHREN DAFÜR SOWIE ANZEIGEVORRICHTUNG
SUBSTRAT DE RÉSEAU, PROCÉDÉ DE FABRICATION ASSOCIÉ ET APPAREIL D'AFFICHAGE

(30) Priority: 30.08.2013 CN 201310388775
(43) Date of publication of application: 10.06.2015
(73) Proprietor: BOE Technology Group Co., Ltd., Beijing 100015 (CN); Ordos Yuansheng Optoelectronics Co., Ltd., Ordos, Inner Mongolia 017020 (CN)
(72) Inventor: SUN, Jian, Beijing 100176 (CN); LI, Cheng, Beijing 100176 (CN); AN, Seongjun, Beijing 100176 (CN); RYU, Bongyeol, Beijing 100176 (CN)
(74) Representative: Cohausz & Florack
(86) International application number: PCT/CN2013/088046
(87) International publication number: WO 2015/027590

(56) References cited:
- CN-A- 1 577 014
- CN-A- 101 685 231
- CN-A- 102 156 368
- CN-A- 102 636 927
- CN-A- 102 938 394
- JP-A- 2008 241 978
- US-A1- 2004 266 040
- P. Yeh & C. Gu: "Optics of Liquid Crystal Displays", 1999, John Wiley & Sons, United States of America, XP002754752, ISBN: 047118201X pages 262-267, * page 262 - page 266; figures 6.9, 6.10 *

## Description

### FIELD OF THE INVENTION

The invention relates to the field of display technology, and in particular, to an array substrate and a manufacturing method thereof and a display device.

### BACKGROUND OF THE INVENTION

The amorphous silicon is limited in many fields because of its low on-state current, low Mobility, and poor stability due to its own defects, in order to compensate for the defects of the amorphous silicon of its own so as to be used widely in related fields, a low temperature poly-silicon(LTPS) is proposed.

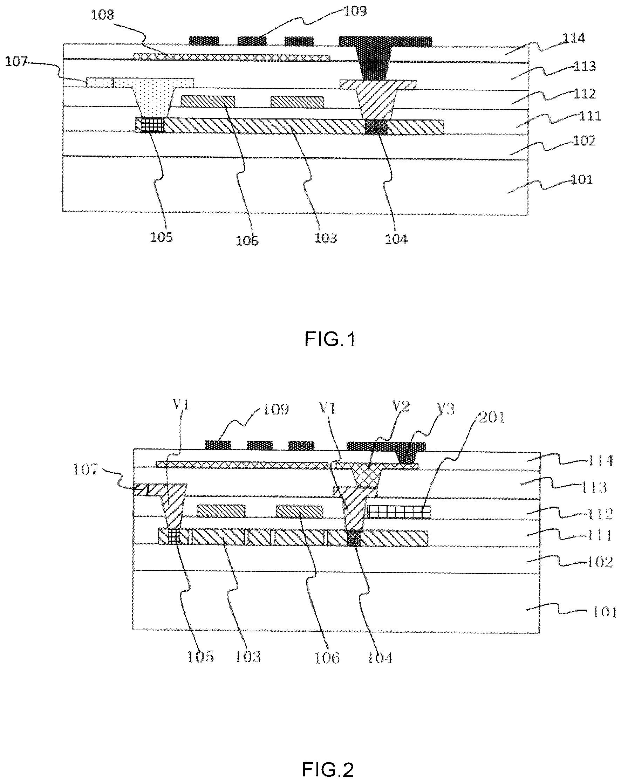

With the development of the thin film transistor liquid crystal display (TFT-LCD) technology, a display technology based on the low temperature poly-silicon has become a mainstream. As shown in FIG.1, in the prior art, an array substrate based on thin film transistors made of low temperature poly-silicon comprises: a base substrate 101, a buffer layer 102, an active region 103, a gate electrode 106, a source electrode 105, a drain electrode 104, a data line 107, a transparent common electrode 108, a pixel electrode 109, a gate insulating layer 111, an intermediate dielectric layer 112, a flattening layer 113 and a passivation layer 114.

To satisfy the requirements on the development of pixel technology, how to increase the storage capacitance is focused on. In the prior art, increase of the storage capacitance is realized as follows: as shown in FIG.2, a common electrode line 201 is provided in the array substrate, wherein the common electrode line 201 is provided in the same layer as the gate electrode 106, and forms a storage capacitor with a pixel electrode 109 thereabove.

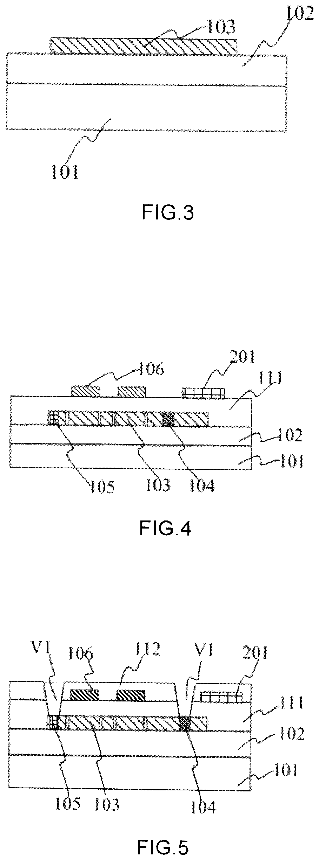

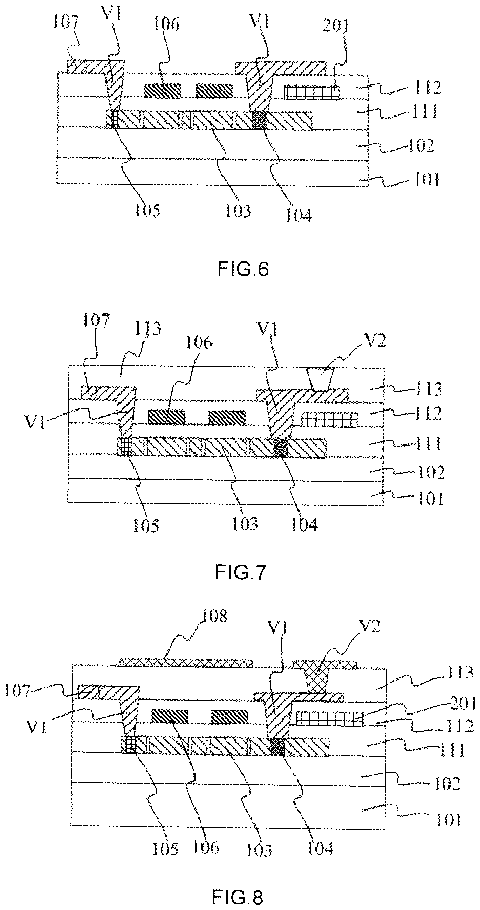

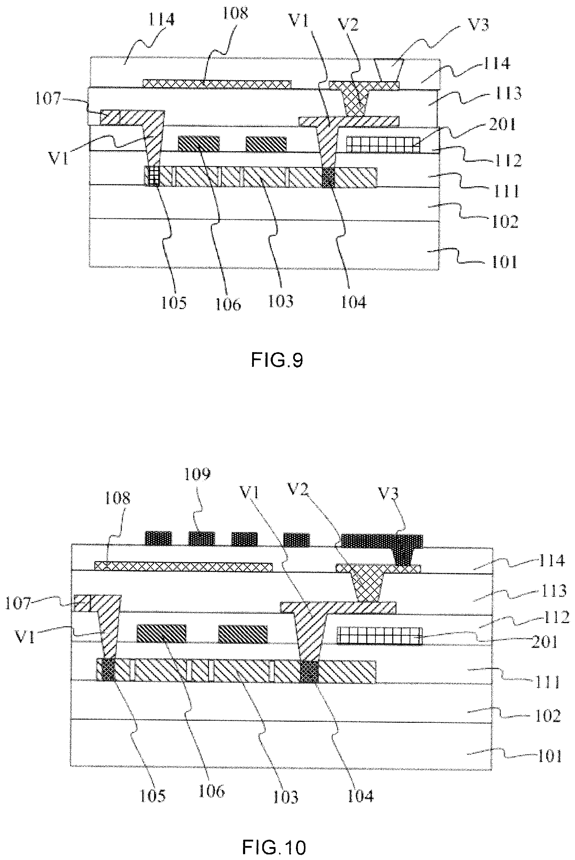

The manufacturing process of the array substrate based on thin film transistors made of low temperature poly-silicon as shown in FIG.2 comprises:
A first step, forming a buffer layer 102 on a base substrate 101, as shown in FIG.3.
A second step, forming an active region 103 on the base substrate subjected to the first step by using a patterning process, as shown in GIG.3.
A third step, forming a gate insulating layer 111 by depositing a silicon oxide layer or a silicon nitride layer on the base substrate subjected to the third step, as shown in FIG.4.
A forth step, forming a gate electrode 106 and a common electrode line 201 on the base substrate subjected to the third step by using a patterning process, as shown in FIG.4.
A fifth step, doping heavily-doped n type impurity ions into both sides of the active region 103 by ion implantation, to form a source electrode 105 and a drain electrode 104 on the opposite sides of the active region 103 respectively, as shown in FIG.4.
A sixth step, forming an intermediate dielectric layer 112 by depositing a silicon oxide layer or a silicon nitride layer on the base substrate subjected to the fifth step, and forming a via V1 penetrating through the gate insulating layer 111 and the intermediate dielectric layer 112 by using a patterning process, as shown in FIG.5.
A seventh step, forming a data line 107 on the base substrate subjected to the sixth step so that the data line 107 is electrically connected to the source electrode 105 through the via V1, as shown in FIG.6.
An eighth step, forming a flattening layer 113 on the base substrate subjected to the seventh step, and forming a via V2 penetrating through the flattening layer 113 by using a patterning process, as shown in FIG.7.
A ninth step, depositing a layer of transparent conductive thin film on the base substrate subjected to the eighth step by magnetron sputtering, and then forming a transparent common electrode 108 by using a patterning process, as shown in FIG.8.
A tenth step, forming a passivation layer 114 on the base substrate subjected to the ninth step, and forming a via V3 penetrating through the passivation layer 114 by using a patterning process, as shown FIG.9.
An eleventh step, depositing a layer of indium-tin oxide (ITO) transparent conductive thin film on the base substrate subjected to the tenth step by magnetron sputtering, and then forming a pixel electrode 109 by using a patterning process so that the pixel electrode 109 is electrically connected to the drain electrode 104 through the vias V1, V2 and V3, as shown in FIG.10.

From the above description with respect to the method for manufacturing the array substrate based on thin film transistors made of low temperature poly-silicon in the prior art, it can be seen that although the common electrode line 201 and the gate electrode 106 are formed by using a single exposure process, at least eight patterning processes including exposure, etching etc. are required in the method for manufacturing the array substrate, therefore the method for manufacturing the array substrate has defects such as complicated manufacturing process, large number of processes, high cost and spending more time.

The Chinese patent application CN 102 938 394 A describes a display device, a transflective thin film transistor array substrate and a manufacturing method thereof, the manufacturing method comprises: providing a substrate; forming a gate line, a data line which is broken when passing through a gate line area, a gate electrode, a reflective electrode and a common electrode line; forming a patterned gate insulating layer and an active layer located above the gate insulating layer; forming a pixel electrode, a source electrode, a drain electrode, a connection line of the data line and a channel; forming a passivation layer and a common electrode via hole; forming a common electrode.

The publication P. Yeh & C. Gu: "Optics of Liquid Crystal Display", 1999, John Wiley & Sons, ISBN 047118201X, XP-002754752, pages 262-266 describres an inverted staggert TFT structure and a coplanar TFT structure. In both TFT structures the pixel ITO electrode is arranged adjacent to the thin film transistor.

The US patent application US 2004/266040 A1 discloses a method for fabricating an in-plane switching LCD device including forming a data line and a light-shielding layer on a substrate, forming a pixel electrode line and an active region with a polycrystalline silicon thin film, forming a first insulating layer on the substrate, forming a gate electrode and a common electrode line on the first insulating layer, forming a second insulating layer on the substrate, forming a first contact hole that exposes at least portions of the data line and the active region, and forming a connection electrode that connects at least portions of the exposed data line and the active region.

### SUMMARY OF THE INVENTION

Embodiments of the present invention provide an array substrate and a manufacturing method thereof and a display device, which can solve the problems such as complicated manufacturing process, large number of processes, high cost and spending more time in manufacturing the array substrate in the prior art, while can realize the purpose for increasing the storage capacitance.

An array substrate in the present invention comprises a base substrate and data lines and scan lines provided on the base substrate, the data lines and the scan lines define pixel regions, each of the pixel regions is provided with a thin film transistor, a pixel electrode, a common electrode and a common electrode line thereinside, the thin film transistor comprises a gate electrode, a source electrode, a drain electrode and an active layer, the gate electrode is provided above the active layer, the source electrode and the drain electrode are provided on opposite sides of the active layer respectively, wherein the data line and the common electrode line are provided in the same layer on the base substrate and below the active layer, the data line and the common electrode line are provided separately, the common electrode is provided with a connection part which at least partly overlaps with the common electrode line in an orthographic projection direction, the common electrode is electrically connected to the common electrode line through a first via between the connection part and the common electrode line, the pixel electrode is provided above the gate electrode, and the common electrode line is formed below the drain electrode. In the array substrate, the common electrode line and a pixel electrode thereabove form a storage capacitor, so that the storage capacitance is increased, meanwhile, as the common electrode line and the data line are provide in the same layer, they may be formed by a single exposure process, so that the manufacturing procedure is reduced, the manufacturing process is simplified, and the manufacturing cost is saved and the manufacturing time is shortened.

For example, the data line is made of the same conductive material as the common electrode line, so that the data line and the common electrode line may be made by a single process, meanwhile, the manufacturing cost is saved.

For example, the active layer is made of a low temperature poly-silicon material, the source electrode and the drain electrode are formed on the opposite sides of the active layer by ion implantation so that a conductive channel will be formed between the source electrode and the drain electrode, and the common electrode line is formed below the drain electrode.

For example, the array substrate further comprises a buffer layer which is provided below the active layer and above the base substrate, and covers the data line and the common electrode line. The buffer layer is used to prevent the impurities contained in the base substrate from diffusing into the active layer of the thin film transistor in subsequent processes, thereby avoiding the influence on characteristics such as a threshold voltage and a leakage current of the thin film transistor, so as to improve the quality of the thin film transistor.

For example, the array substrate further comprises a gate insulating layer provided above the active layer and below the gate electrode, for electrically isolating the active layer from the gate electrode.

For example, the array substrate further comprises an intermediate dielectric layer provided above the gate electrode for electrically isolating the gate electrode from other electrodes on the intermediate dielectric layer.

For example, a second via is provided in positions of the buffer layer, the gate insulating layer and the intermediate dielectric layer corresponding to the data line, a third via is provided in positions of the gate insulating layer and the intermediate dielectric layer corresponding to the source electrode, and the data line is electrically connected to the source electrode through the second via and the third via.

For example, the array substrate further comprises a pixel electrode provided on the intermediate dielectric layer and a passivation layer provided between the pixel electrode and the common electrode, and the pixel electrode partly overlaps with the common electrode in the orthographic projection direction;

the common electrode is provided above the passivation layer, the pixel electrode is provided below the passivation layer, a forth via is provided in positions of the gate insulating layer and the intermediate dielectric layer corresponding to the drain electrode, the pixel electrode is electrically connected to the drain electrode through the forth via, the common electrode is slit-shaped, the pixel electrode is plate-shaped or slit-shaped, and the first via between the connection part and the common electrode line penetrates through the buffer layer, the gate insulating layer, the intermediate dielectric layer and the passivation layer; or the common electrode is provided below the passivation layer, the pixel electrode is provided above the passivation layer, a forth via is provided in positions of the gate insulating layer and the intermediate dielectric layer corresponding to the drain electrode, a fifth via is provided in a position of the passivation layer corresponding to the drain electrode, the pixel electrode is electrically connected to the drain electrode through the forth via and the fifth via, the common electrode is plate-shaped or slit-shaped, the pixel electrode is slit-shaped, and the first via between the connection part and the common electrode line penetrates through the buffer layer, the gate insulating layer, the intermediate dielectric layer.

For example, the array substrate further comprises a light blocking metal layer which is provided in the same layer as the data line and the common electrode line on the base substrate, and is provided below the active layer and at least partly overlaps with the active layer in the orthographic projection direction.

The light blocking metal layer is provided between regions corresponding to the source electrode and the drain electrode, and at least partly overlaps with the gate electrode in the orthographic projection direction, and the light blocking metal layer is used to partly block the light irradiated towards the region between the drain electrode and the drain electrode, so that the leakage current of the thin film transistor is reduced.

For example, the active layer is provided with lightly doped drain electrodes, which are provided between the source electrode and the drain electrode and on the opposite sides of a region corresponding to the gate electrode. The lightly doped drain electrodes may also be used to reduce the leakage current of the thin film transistor.

Embodiments of the present invention provide a display device comprising any one of the above array substrates.

Embodiments of the present invention provide a manufacturing method of an array substrate, comprising a step of forming data lines, scan lines, common electrodes and common electrode lines and a step of forming thin film transistors, the step of forming a thin film transistor comprises a step of forming a gate electrode, a source electrode, a drain electrode and an active layer, each of pixel regions defined by the scan lines and the common electrode lines has a common electrode, a common electrode line, a pixel electrode, and a thin film transistor, wherein the data line and the common electrode line are provided in the same layer on the base substrate and below the active layer, a connection part is provided in the same layer as the common electrode and is provided on the common electrode, and at least partly overlaps with the common electrode line in an orthographic projection direction, the common electrode is electrically connected to the common electrode line through a first via between the connection part and the common electrode line, wherein the pixel electrode is provided above the gate electrode and the common electrode line is formed below the drain electrode. For example, the manufacturing method of an array substrate specifically comprises:
forming a pattern containing the data line and the common electrode line, which are provided separately, on the base substrate by using a patterning process;
forming a buffer layer and a pattern containing the active layer, the buffer layer covers the data line and the common electrode line, and the pattern containing the active layer is formed on the buffer layer;
forming a gate insulating layer and a pattern containing the gate electrode; and
forming a pattern containing the source electrode and the drain electrode, the source electrode and the drain electrode are formed on opposite sides of the active layer by ion implantation.

For example, the manufacturing method further comprise following steps of forming the common electrode, the connection part and a pixel electrode:
forming an intermediate dielectric layer and a pattern containing the first via, a second via, a third via and a forth via, wherein the first via is formed between the connection part and the common electrode line and penetrates through the buffer layer, the gate insulating layer and the intermediate dielectric layer, the second via is formed in a position corresponding to the data line and penetrates through the buffer layer, the gate insulating layer and the intermediate dielectric layer, the third via is formed in a position corresponding to the source electrode and penetrates through the gate insulating layer and the intermediate dielectric layer, and the forth via is formed in a position corresponding to the drain electrode and penetrates through the gate insulating and the intermediate dielectric layer;
forming a pattern containing the common electrode and the connection part, wherein the first via, the second via, the third via and the forth via are filled with a conductive material used for forming the common electrode, the connection part is electrically connected to the common electrode line through the first via, and the data line is electrically connected to the source electrode through the second via and the third via;
forming a passivation layer and forming a pattern containing a fifth via in the passivation layer, wherein the fifth via is formed in a position corresponding to the drain electrode, and the position of the fifth via corresponds to that of the fifth via; and
forming a pattern containing the pixel electrode, wherein the fifth via is filled with a conductive material used for forming the pixel electrode, and the pixel electrode is electrically connected to the drain electrode through the forth via and the fifth via.

The above steps for forming the common electrode, the connection part and the pixel electrode are applicable to the array substrate in which the common electrode is provided below the pixel electrode. As for the array substrate in which the common electrode is provided above the pixel electrode, the manufacturing method further comprises following steps of forming the common electrode, the connection part and a pixel electrode:
forming an intermediate dielectric layer and a pattern containing a second via, a third via and a forth via, wherein the second via is formed in a position corresponding to the data line and penetrates through the buffer layer, the gate insulating layer and the intermediate dielectric layer, the third via is formed in a position corresponding to the source electrode and penetrates through the gate insulating layer and the intermediate dielectric layer, and the forth via is formed in a position corresponding to the drain electrode and penetrates through the gate insulating layer and the intermediate dielectric layer;
forming a pattern containing the pixel electrode, wherein the second via, the third via and the forth via are filled with a conductive material used for forming the common electrode, the data line is electrically connected to the source electrode through the second via and the third via, and the pixel electrode is electrically connected to the drain electrode through the forth via;
forming a passivation layer and a pattern containing the common electrode and the connection part, the passivation layer covers the pixel electrode completely, the pattern containing the common electrode and the connection part is formed above the passivation layer; and
forming the first via between the connection part and the common electrode line, the first via penetrates through the buffer layer, the gate insulating layer, the intermediate dielectric layer and the passivation layer.

For example, the step of forming the source electrode and the drain electrode comprises forming lightly doped drain electrodes in the active layer by ion implantation, the lightly doped drain electrodes are formed between the source electrode and the drain electrode and on opposite sides of a region corresponding to the gate electrode. The lightly doped drain electrodes may be used to reduce the leakage current of the thin film transistor.

For example, the step of forming a pattern containing the data line and the common electrode line comprises: forming a light blocking metal layer on the base substrate so that the light blocking metal layer is provided in the same layer as the data line and the common electrode line, is provided below the active layer and at least partly overlaps with the active layer in the orthographic projection direction.

For example, at least one light blocking metal layer is formed in the step of forming a pattern containing the data line and the common electrode line, at least one gate electrode is formed in the step of forming the gate insulating layer and a pattern containing the gate electrode, and the light blocking metal layer is formed in a position corresponding to that of the gate electrode to reduce the leakage current of the thin film transistor.

### BRIEF DESCRIPTION OF THE DRAWINGS

FIG. 1 is a cross-sectional view of a structure of an array substrate in the prior art;
FIG. 2 is a cross-sectional view of a structure of another array substrate in the prior art;
FIGs.3 to 10 are cross-sectional views of structures formed at respective steps of a manufacturing method of the array substrate shown in FIG.2;
FIG.11 is a cross-sectional view of a structure of an array substrate according to an embodiment of the invention;
FIG.12 a cross-sectional view of a structure of an array substrate according to another embodiment of the invention;
FIGs.13 to 17 are cross-sectional views of structures formed at respective steps of a manufacturing method of an array substrate provided in a first embodiment of the invention;
FIG.18 is a cross-sectional view of the structure with an intermediate dielectric layer formed thereon of an array substrate provided in a second embodiment of the invention; and
FIG.19 is a cross-sectional view of the structure with a pixel electrode formed thereon of the array substrate provided in the second embodiment of the invention.

### DETAILED DESCRIPTION OF THE EMBODIMENTS

Embodiments of the present invention provide an array substrate and a manufacturing method thereof and a display device, which can solve the problems such as complicated manufacturing process, large number of processes, high cost and spending more time in manufacturing the array substrate in the prior art, while can realize the purpose for increasing the storage capacitance.

The technical solutions in the embodiments of the present invention will be described clearly and thoroughly hereinafter in conjunction with the drawings of the embodiments of the present invention. Obviously, the embodiments described herein are only a part, rather than all, of the embodiments of the present invention. All the other embodiments obtained by skilled persons in the art in light of the embodiments of the present invention without any creative work fall within the protection scope of the present invention.

An array substrate in the present invention comprises a base substrate and data lines and scan lines provided on the base substrate, the data lines and the scan lines define pixel regions, each of the pixel regions is provided with a thin film transistor, a common electrode and a common electrode line thereinside, the thin film transistor comprises a gate electrode, a source electrode, a drain electrode and an active layer, the gate electrode is provided above the active layer, the source electrode and the drain electrode are provided on opposite sides of the active layer respectively, wherein the data line and the common electrode line are provided in the same layer on the base substrate and are provided below the active layer, the data line and the common electrode line are provided separately, a connection part is provided on the common electrode and at least partly overlaps with the common electrode line in an orthographic projection direction, and the common electrode is electrically connected to the common electrode line through a first via between the connection part and the common electrode line.

The data line and the common electrode line provided in the same layer are made of the same conductive material.

The active layer is made of low temperature poly-silicon material, the source electrode and the drain electrode are formed on the opposite sides of the active layer by ion implantation, and the common electrode line is formed below the drain electrode.

Further, the array substrate comprises a buffer layer which is provided below the active layer and above the base substrate, and covers the data line and the common electrode line. Of course, the position at which the buffer layer is provided is not limited thereto, for example, the buffer layer may be provided above the base substrate and below the data line and the common electrode line.

Further, the array substrate comprises a gate insulating layer provided above the active layer and below the gate electrode.

Further, the array substrate comprises an intermediate dielectric layer provided above the gate electrode.

A second via is provided in positions of the buffer layer, the gate insulating layer and the intermediate dielectric layer corresponding to the data line, a third via is provided in positions of the gate insulating layer and the intermediate dielectric layer corresponding to the source electrode, and the data line is electrically connected to the source electrode through the second via and the third via.

Further, the array substrate comprises a pixel electrode provided on the intermediate dielectric layer and a passivation layer provided between the pixel electrode and the common electrode, the pixel electrode partly overlaps with the common electrode in the orthographic projection direction;
When the common electrode is provided above the passivation layer, and the pixel electrode is provided below the passivation layer, a forth via is provided in positions of the gate insulating layer and the intermediate dielectric layer corresponding to the drain electrode, the pixel electrode is electrically connected to the drain electrode through the forth via, the common electrode is slit-shaped, the pixel electrode is plate-shaped or slit-shaped, and the first via between the connection part and the common electrode line penetrates through the buffer layer, the gate insulating layer, the intermediate dielectric layer and the passivation layer, and

When the common electrode is provided below the passivation layer, and the pixel electrode is provided above the passivation layer, a forth via is provided in positions of the gate insulating layer and the intermediate dielectric layer corresponding to the drain electrode, a fifth via is provided in a position of the passivation layer corresponding to the drain electrode, the pixel electrode is electrically connected to the drain electrode through the forth via and the fifth via, the common electrode is plate-shaped or slit-shaped, the pixel electrode is slit-shaped, and the first via between the connection part and the common electrode line penetrates through the buffer layer, the gate insulating layer, and the intermediate dielectric layer.

Further, the array substrate comprises a light blocking metal layer which is provided in the same layer with the data line and the common electrode line on the base substrate, and is provided below the active layer and at least partly overlaps with the active layer in the orthographic projection direction.

Also, the light blocking metal layer is provided between regions corresponding to the source electrode and the drain electrode, and at least partly overlaps with the gate electrode in the orthographic projection direction.

Further, the active layer is provided with lightly doped drain electrodes, which are provided between the source electrode and the drain electrode and on opposite sides of a region corresponding to the gate electrode.

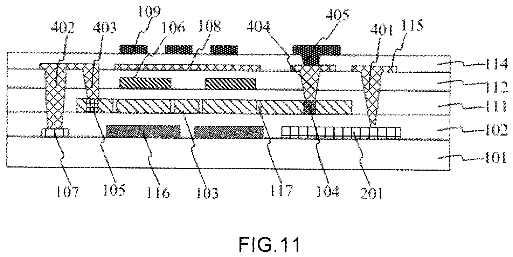

An array substrate is provided in the first embodiment, with reference to FIG. 11, wherein FIG.11 is a cross-sectional view of the structure of an array substrate according to the first embodiment of the invention. With reference to FIG. 11, the array substrate comprises a base substrate 101, a common electrode line 201, data lines 107, a buffer layer 102, an active layer 103, a drain electrode 104, a source electrode 105, a gate electrode 106, a common electrode 108, a pixel electrode 109, scan lines intersecting with the data lines 107, a gate insulating layer 111 between the active layer 103 and the gate electrode 106, an intermediate dielectric layer 112 between the gate electrode 106 and the common electrode 108, a passivation layer 114 between the common electrode 108 and the pixel electrode 109, and a connection part 115 provided on the common electrode.

Specifically, the common electrode line 201 and the data lines 107 are provided in the same layer and located between the base substrate 101 and the buffer layer 102. Also, the common electrode line 201 and the data lines 107 are made of the same material. In addition, the common electrode line 201 and the data lines 107 may be formed in a single patterning process.

The buffer layer 102 is above the common electrode line 201 and the data lines 107 and below the active layer 103, and the buffer layer 102 covers the common electrode line 201 and the data lines 107 therebelow.

In the embodiment, the buffer layer 102 is used for preventing impurities contained in the base substrate from diffusing into the active layer 103 of the thin film transistor in the subsequent processes, thereby avoiding the influence on the characteristics such as the threshold voltage and the leakage current of the thin film transistor. Meanwhile, as the active layer 103 is made of low temperature poly-silicon material which is normally formed by using excimer laser anneal method, the buffer layer 102 is provided to prevent impurities due to the excimer laser anneal from diffusing into the active layer 103 in the subsequent process for forming the active layer 103, therefore the quality of the thin film transistor made of low temperature poly-silicon material may be improved.

The active layer 103 is above the buffer layer 102 and below the gate insulating layer 111, and the active layer 103 is made of low temperature poly-silicon material.

The drain electrode 104 and the source electrode 105 are located on the opposite sides of the active layer 103 respectively, and the drain electrode 104 and the source electrode 105 are formed by ion implantation.

The gate electrode 106 and the scan lines are provided in the same layer and located between the gate insulating layer 111 and the intermediate dielectric layer 112. Also, the gate electrode 106 and the scan lines are made of the same material and may be formed in a single patterning process.

The common electrode 108 is above the intermediate dielectric layer 112 and below the passivation layer 114, and the common electrode 108 may be made of a transparent conductive material such as indium-tin oxide (ITO) and may be plate-shaped or slit-shaped.

The connection part 115, which is provided in the same layer as the common electrode 108, may be made of the same transparent conductive material as the common electrode 108, and may at least partly overlap with the common electrode line 201 in the orthographic projection direction.

The pixel electrode 109 is above the passivation layer 114 and may be made of a transparent conductive material such as indium-tin oxide, and the pixel electrode 109 may be slit-shaped. The pixel electrode 109 at least partly overlaps with the common electrode 108 in the orthographic projection direction.

The array substrate is further provided with a first via 401, a second via 402, a third via 403, a forth via 404 and a fifth via 405.

Specifically, the first via 401 sequentially penetrates through the intermediate dielectric layer 112, the gate insulating layer 111 and the buffer layer 102, so that the common electrode line 201 is electrically connected to the common electrode 108 so as to apply a common voltage signal to the common electrode 108.

The second via 402 is provided in positions of the buffer layer 102, the gate insulating layer 111 and the intermediate dielectric layer 112 corresponding to the data line 107.

The third via 403 is provided in positions of the gate insulating layer 111 and the intermediate dielectric layer 112 corresponding to the source electrode 105, so that the source electrode 105 may be electrically connected to the data line 107 through the second via 402 and the third via 403.

The forth via 404 is provided in positions of the gate insulating layer 111 and the intermediate dielectric layer 112 corresponding to the drain electrode 104.

The fifth via 405 is provided in a position of the passivation layer 114 corresponding to the drain electrode 104, so that the drain electrode 104 may be electrically connected to the pixel electrode 109 through the forth via 404 and the fifth via 405.

The first via 401, the second via 402, the third via 403, the forth via 404 and the fifth via 405 are filled with a transparent conductive material for forming the common electrode 108, and the fifth via 405 is filled with a transparent conductive material for forming the pixel electrode 109.

In the embodiment, the array substrate may also comprise a light blocking metal layer 116 which is provided in the same layer as the data line 107 and the common electrode line 201 on the base substrate 101, and is provided below the active layer 103 and at least partly overlaps with the active layer 103 in the orthographic projection direction. The light blocking metal layer 116 is provided between regions corresponding to the source electrode 105 and the drain electrode 104, and at least partly overlaps with the gate electrode 106 in the orthographic projection direction. The light blocking metal layer 116 may block light for the channel region of the active layer 103, so that the light irradiated towards the active layer 103 may be partly blocked, thus the leakage current of the active layer 103 is reduced. Of course, the light blocking metal layer 116 may overlap with the active layer 103 completely, thereby the light blocking metal layer 116 may block the entire active layer 103, so that the light irradiated towards the active layer 103 may be completely blocked, thus the leakage current of the active layer 103 is further reduced.

The light blocking metal layer 116, the common electrode line 201 and the data lines 107 are made of the same conductive material, so that the light blocking metal layer 116, the common electrode line 201 and the data lines 107 provided in the same layer may be formed in a single patterning process. Also, as the conductive material is an opaque conductive material, the light blocking metal layer 116 may partly block the light irradiated towards the active layer 103, and thereby the leakage current of the thin film transistor may be reduced.

The array substrate in the embodiment may also comprise lightly doped drain electrodes 117 provided in the active layer 103, which are provided between the source electrode 105 and the drain electrode 104 and on the opposite sides of a region corresponding to the gate electrode 106. The lightly doped drain electrodes 117 in the embodiment may also be used to reduce the leakage current of the thin film transistor.

In the embodiment, at least one gate electrode 106 may be formed, and at least one light blocking metal layer 116 may be formed. More specifically, in the embodiment, two gate electrodes 106 are provided, which may reduce the leakage current of the thin film transistor, meanwhile, two light blocking metal layers 116 may be provided.

It should be noted that, a flattening layer may be provided between the intermediate dielectric layer 112 and the common electrode 108 to make the intermediate dielectric layer 112 keep flat. Of course, alternatively, no flattening layer is provided between the intermediate dielectric layer 112 and the common electrode 108 as in the embodiment, which can make the array substrate relatively thin.

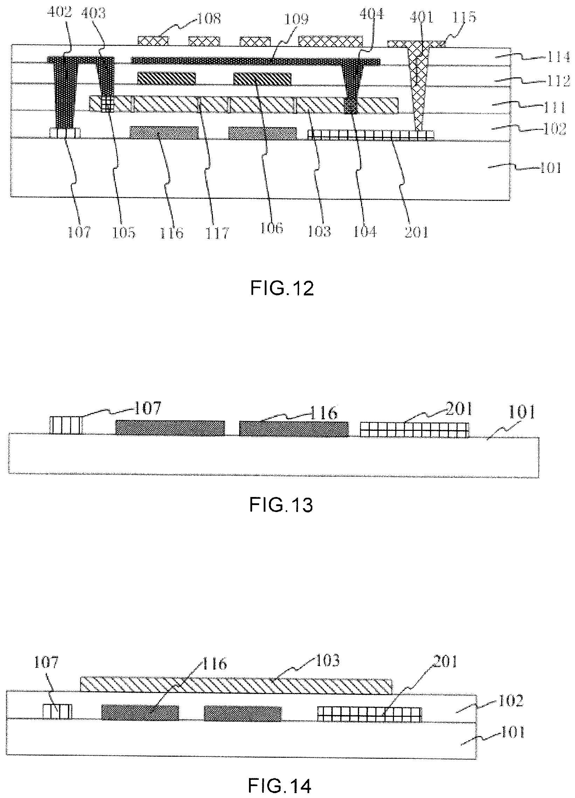

The second embodiment of the present invention also provides an array substrate, the cross-sectional view of the structure of which is shown in FIG.12, and it can be seen from FIG.12 that this array substrate is substantially the same as that of the array substrate shown in FIG.2 in structure except the following differences: first, in the array substrate shown in FIG.12, the pixel electrode 109 is above the passivation layer 114, and the common electrode 108 is below the passivation layer 114, however, in the array substrate shown in FIG.12, the pixel electrode 109 is below the passivation layer 114, and the common electrode 108 is above the passivation layer 114; second, it is not required to provide a fifth via in the array substrate shown in FIG.12; third, in the array substrate shown in FIG.12, the first via for connecting the common electrode with the common electrode line sequentially penetrates through the intermediate dielectric layer 112, the gate insulating layer 111 and the buffer layer 102, however, in the array substrate shown in FIG.12, the first via for connecting the common electrode with the common electrode line sequentially penetrates through the passivation layer 114, the intermediate dielectric layer 112, the gate insulating layer 111 and the buffer layer 102. The array substrate in the second embodiment of the invention has a simpler structure, and the manufacturing method thereof is further simplified, the process time is shortened, and the manufacturing cost is reduced.

A third embodiment of the invention provides a manufacturing method of an array substrate, which comprises a step of forming data lines, scan lines, common electrodes and common electrode lines and a step of forming thin film transistors, the step of forming a thin film transistor comprises a step of forming a gate electrode, a source electrode, a drain electrode and an active layer, each of pixel regions defined by the scan lines and the data lines has a common electrode, a common electrode line and a thin film transistor, wherein, the data line and the common electrode line are formed in the same layer on the base substrate and below the active layer, a connection part is provided in the same layer as the common electrode and at least partly overlaps with the common electrode line in an orthographic projection direction, the common electrode is electrically connected to the common electrode line through a first via formed between the connection part and the common electrode line.

In the actual manufacturing process, the manufacturing method of an array substrate specifically comprises:
a first step, forming a pattern containing a data line and a common electrode line, which are provided separately, on a base substrate by using a patterning process;
a second step, forming a buffer layer and a pattern containing an active layer on the base substrate subjected to the first step, wherein the buffer layer covers the data line and the common electrode line, and the pattern containing the active layer is formed on the buffer layer;
a third step, forming a gate insulating layer and a pattern containing a gate electrode on the base substrate subjected to the second step; and
a forth step, forming a pattern containing a source electrode and a drain electrode on the base substrate subjected to the third step, wherein the source electrode and the drain electrode are formed on the opposite sides of the active layer by ion implantation;
a fifth step, forming an intermediate dielectric layer and a pattern containing a first via, a second via, a third via and a forth via on the base substrate subjected to the forth step, wherein the first via is formed between the connection part and the common electrode line and penetrates through the buffer layer, the gate insulating layer and the intermediate dielectric layer, the second via is formed in a position corresponding to the data line and penetrates through the buffer layer, the gate insulating layer and the intermediate dielectric layer, the third via is formed in a position corresponding to the source electrode and penetrates through the gate insulating layer and the intermediate dielectric layer, and the forth via is formed in a position corresponding to the drain electrode and penetrates through the gate insulating layer and the intermediate dielectric layer;
a sixth step, forming a pattern containing a common electrode and its connection part on the base substrate subjected to the fifth step, wherein the first via, the second via, the third via and the forth via are filled with a conductive material used for forming the common electrode, the connection part is electrically connected to the common electrode line through the first via, and the data line is electrically connected to the source electrode through the second via and the third via;
a seventh step, forming a passivation layer on the base substrate subjected to the sixth step and forming a pattern containing a fifth via in the passivation layer, wherein the fifth via is formed in a position corresponding to the drain electrode, and the position of the fifth via corresponds to the position of the forth via; and
a eighth step, forming a pattern containing a pixel electrode on the base substrate subjected to the seventh step, wherein the fifth via is filled with a conductive material used for forming the pixel electrode, and the pixel electrode is electrically connected to the drain electrode through the forth via and the fifth via.

The fifth step to the eighth step are applicable to an array substrate in which the common electrode is below the pixel electrode. However, as to an array substrate in which the common electrode is above the pixel electrode, the manufacturing method further comprises following steps of forming a common electrode and its connection part, and a pixel electrode:
a fifth step, forming a intermediate dielectric layer and a pattern containing a second via, a third via and a forth via on the base substrate subjected to the forth step, wherein the second via is formed in a position corresponding to the data line and penetrates through the buffer layer, the gate insulating layer and the intermediate dielectric layer, the third via is formed in a position corresponding to the source electrode and penetrates through the gate insulating layer and the intermediate dielectric layer, and the forth via is formed in a position corresponding to the drain electrode and penetrates through the gate insulating layer and the intermediate dielectric layer;
a sixth step, forming a pattern containing a pixel electrode on the base substrate subjected to the fifth step, wherein the second via, the third via and the forth via are filled with a conductive material used for forming the pixel electrode, the data line is electrically connected to the source electrode through the second via and the third via, and the pixel electrode is electrically connected to the drain electrode through the forth via;
a seventh step, forming a passivation layer and a pattern containing a common electrode and its connection part on the base substrate subjected to the sixth step, wherein the passivation layer covers the pixel electrode completely, and the pattern containing the common electrode and the connection part is formed above the passivation layer; and forming a first via between the connection part and the common electrode line, the first via penetrates through the buffer layer, the gate insulating layer, the intermediate dielectric layer and the passivation layer.

The forth step further comprises forming lightly doped drain electrodes in the active layer by ion implantation, wherein the lightly doped drain electrodes are formed between the source electrode and the drain electrode and on the opposite sides of a region corresponding to the gate electrode, the lightly doped drain electrodes may be used to reduce the leakage current of the thin film transistor.

Further, the first step comprises forming a light blocking metal layer in the same layer as the data line and the common electrode line on the base substrate, wherein the light blocking metal layer is provided below the active layer and at least partly overlaps with the active layer in the orthographic projection direction.

For example, at least one light blocking metal layer is formed in the first step, at least one gate electrode is formed in the third step, and the light blocking metal layer is formed in a position corresponding to that of the gate electrode for reducing the leakage current of the thin film transistor.

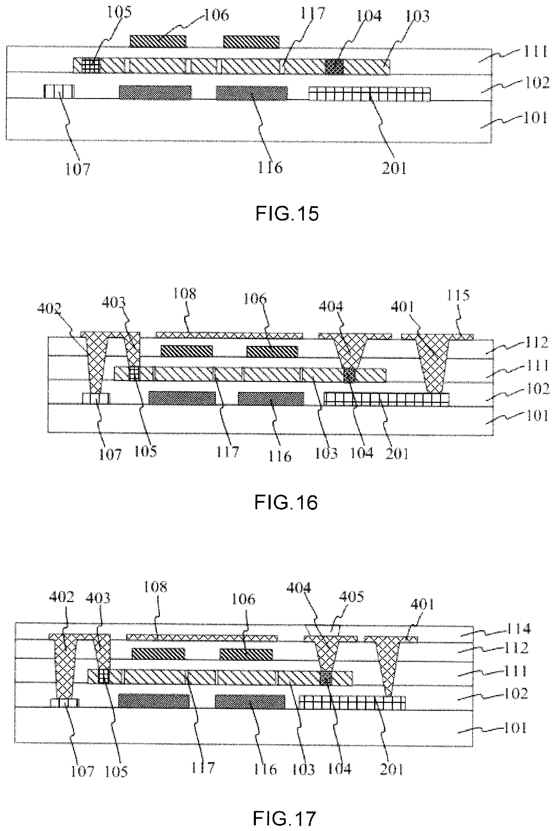

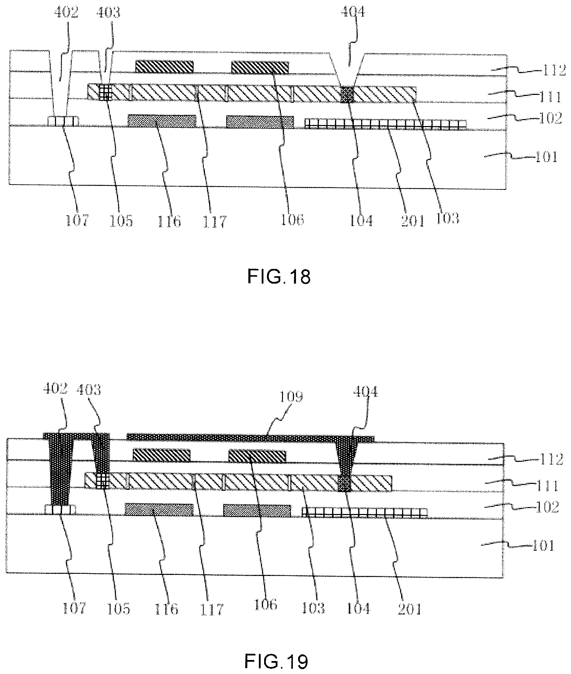

Hereinafter, the manufacturing method of an array substrate provided in the third embodiment of the invention will be described in detail with reference to accompanying drawings and taking the structure of the array substrate in the first embodiment as an example, the manufacturing method of an array substrate specifically comprises:
a first step, as shown in FIG.13, depositing a layer of metal thin film on the base substrate 101, and then forming a pattern containing a data line 107, a light blocking metal layer 116 and a common electrode line 201 through a first patterning process, wherein the data line 107, the light blocking metal layer 116 and the common electrode line 201 are provided separately.
   In the invention, the used patterning process may only include lithography process, or, include lithography process and etching process, and in addition, may include other processes for forming a predetermined pattern such as printing and inkjetting. The lithography process refers to a process including film forming, exposure and development etc. for forming a pattern by using photo resist, mask plate and exposure machine etc. Corresponding patterning process may be selected according to structure to be formed in the invention.
   In the embodiment, the patterning process comprises: first, forming (such as sputtering or coating) a layer of metal thin film for forming data lines 107, the light blocking metal layer 116 and the common electrode line 201 on the base substrate 101; next, coating a layer of photo resist on the metal thin film; then exposing the photo resist to light by using a mask plate provided with a pattern including data lines 107, the light blocking metal layer 116 and the common electrode line 201; finally, forming the pattern including the data lines 107, the light blocking metal layer 116 and the common electrode line 201 by using development and etching. In the manufacturing method of an array substrate, the process for manufacturing other film layers by using a patterning process is the same as above, thus description thereof will not be described.
a second step, with reference to FIG.14, depositing a silicon oxide or silicon nitride layer on the base substrate subjected to the first step through plasma enhanced chemical vapor deposition (PEVCD) to form a buffer layer 102, the buffer layer 102 covers the data lines 107, the light blocking metal layer 116 and the common electrode line 201.
a third step, with reference to FIG.14, on the base substrate 101 subjected to the second step, forming an amorphous silicon thin film layer on the buffer layer 102 through PECVD or other similar techniques, then, crystallizing the amorphous silicon by using a laser annealing process or a solid phase crystallization process to form a poly-silicon thin film layer, and next, forming a pattern including a low temperature poly-silicon active layer 103 by using a second patterning process. The active layer 103 is formed on the buffer layer 102, and the pattern of the active layer 103 overlaps with the common electrode line 201 in the orthographic projection direction.
a forth step, with reference to FIG.15, depositing a silicon nitride (SiNx) or silicon oxide (SiOx) layer on the base substrate 101 subjected to the third step to form a gate insulating layer 111, the gate insulating layer 111 is provided above the active layer 103 and below the gate electrode 106.
a fifth step, with reference to FIG.15, depositing a metal layer of Mo, Al or Cr etc. on the base substrate 101 subjected to the forth step, and then forming the gate electrode 106 and scan lines by using a third patterning process.
a sixth step, with reference to FIG16, on the base substrate 101 subjected to the fifth step, performing a heavily doping on the opposite sides of the active layer by ion implantation to form the drain electrode 104 and the source electrode 105, and then performing a lightly doping on the region of the active layer between the drain electrode 104 and the source electrode 105 to form lightly doped drain electrodes 117, wherein the lightly doped drain electrodes 117 are formed between the drain electrode 104 and the source electrode 105 and located on the opposite sides of a region corresponding to the gate electrode 106.
a seventh step, with reference to FIG.16, depositing a silicon nitride (SiNx) or silicon oxide (SiOx) layer on the base substrate 101 subjected to the sixth step to form an intermediate dielectric layer 112, and then forming a first via 401, a second via 402, a third via 403 and a forth via 404 by using a forth patterning process.
   The first via 401 is formed between a connection part 115 and the common electrode line 201 and penetrates through the buffer layer 102, the gate insulating layer 111 and the intermediate dielectric layer 112. The second via 402 is provided in positions of the buffer layer 102, the gate insulating layer 111 and the intermediate dielectric layer 112 corresponding to the data line 107. The third via 403 is provided in positions of the gate insulating layer 111 and the intermediate dielectric layer 112 corresponding to the source electrode 105, so that the source electrode 105 may be electrically connected to the data line 107 through the second via 402 and the third via 403. The forth via 404 is provided in positions of the gate insulating layer 111 and the intermediate dielectric layer 112 corresponding to the drain electrode 104.
an eighth step, with reference to FIG.16, on the base substrate subjected to the seventh step, depositing a layer of indium-tin oxide (ITO) transparent conductive thin film on the intermediate dielectric layer 112 by magnetron sputtering, and then forming a common electrode 108 and its connection part 115 by using a fifth patterning process. The first via 401, the second via 402, the third via 403 and the forth via 404 are filled with an conductive material used for forming the common electrode 108, the connection part 115 is electrically connected to the common electrode line 201 through the first via 401, and the data line 107 is electrically connected to the source electrode 105 through the second via 402 and the third via 403.
a ninth step, with reference to FIG.17, forming a passivation layer 114 on the base substrate subjected to the eighth step, and forming a fifth via 405 by using a sixth patterning process, the fifth via 405 penetrates through the passivation layer 114 and corresponds to the drain electrode 104, so that the pixel electrode may be electrically connected to the drain electrode 104 through the forth via 404 and the fifth via 405.
a tenth step, with reference to FIG.19, on the base substrate subjected to the ninth step, depositing a layer of indium-tin oxide (ITO) transparent conductive thin film on the passivation layer 114 by magnetron sputtering, and then forming a pattern including a pixel electrode 109 by using a seventh patterning process (i.e., after coating photo resist, exposing and developing, performing etching and peeling). The fifth via 405 is filled with a conductive material for forming the pixel electrode 109. The pixel electrode 109 may be electrically connected to the drain electrode 104 through the forth via 404 and the fifth via 405.

Through above steps, the array substrate provided in the first embodiment of the invention, the structure of which is as shown in FIG.12, may be manufactured.

A manufacturing method of the array substrate in the second embodiment of the invention comprises:
a first step, as shown in FIG.13, depositing a layer of metal thin film on the base substrate 101, then forming a pattern containing data lines 107, a light blocking metal layer 116 and a common electrode line 201 through a first patterning process, wherein the data lines 107, the light blocking metal layer 116 and the common electrode line 201 are provided separately.
a second step, with reference to FIG.14, forming a buffer layer 102 on the base substrate subjected to the first step, wherein the buffer layer 102 completely covers the data lines 107, the light blocking metal layer 116 and the common electrode line 201.
a third step, with reference to FIG.14, on the base substrate 101 subjected to the second step, forming a pattern including a low temperature poly-silicon active layer 103 by using a second patterning process. The active layer 103 is formed on the buffer layer 102, and the pattern of the active layer 103 overlaps with the common electrode line 201 in the orthographic projection direction.
a forth step, with reference to FIG.15, depositing a silicon nitride (SiNx) or silicon oxide (SiOx) layer on the base substrate 101 subjected to the third step to form a gate insulating layer 111, the gate insulating layer 111 is provided above the active layer 103 and below the gate electrode 106.
a fifth step, with reference to FIG.15, depositing a metal layer of Mo, Al or Cr etc. on the base substrate 101 subjected to the forth step, and then forming the gate electrode 106 and scan lines by using a third patterning process.
a sixth step, with reference to FIG16, on the base substrate 101 subjected to the fifth step, performing a heavily doping on the opposite sides of the active layer by ion implantation to form the drain electrode 104 and the source electrode 105, and then performing a lightly doping on the region of the active layer between the drain electrode 104 and the source electrode 105 to form lightly doped drain electrodes 117, wherein the lightly doped drain electrodes 117 are formed between the drain electrode 104 and the source electrode 105 and located on the opposite sides of a region corresponding to the gate electrode 106.
a seventh step, with reference to FIG.18, depositing a silicon nitride (SiNx) or silicon oxide (SiOx) layer on the base substrate 101 subjected to the sixth step to form an intermediate dielectric layer 112, and then forming a second via 402, a third via 403 and a forth via 404 by using a forth patterning process.
   The second via 402 is provided in positions of the buffer layer 102, the gate insulating layer 111 and the intermediate dielectric layer 112 corresponding to the data line 107. The third via 403 is provided in positions of the gate insulating layer 111 and the intermediate dielectric layer 112 corresponding to the source electrode 105, so that the source electrode 105 may be electrically connected to the data line 107 through the second via 402 and the third via 403. The forth via 404 is provided in positions of the gate insulating layer 111 and the intermediate dielectric layer 112 corresponding to the drain electrode 104.
an eighth step, with reference to FIG.19, on the base substrate subjected to the seventh step, depositing a layer of indium-tin oxide (ITO) transparent conductive thin film on the intermediate dielectric layer 112 by magnetron sputtering, and then forming a pixel electrode 109 by using a fifth patterning process. The second via 402, the third via 403 and the forth via 404 are filled with a transparent conductive material used for forming the pixel electrode, and the pixel electrode 109 is electrically connected to the drain electrode 104 through the forth via 404.
a ninth step, with reference to FIG.12, forming a passivation layer 114 on the base substrate subjected to the eighth step, and forming a first via 401 by using a sixth patterning process, the first via 401 penetrates through the passivation layer 114, the intermediate dielectric layer 112, the gate insulating layer 111 and the buffer layer102, so that the connection part 115 on the common electrode may be electrically connected to the common electrode line 201 through the first via 401.
a tenth step, with reference to FIG.12, on the base substrate subjected to the ninth step, depositing a layer of indium-tin oxide (ITO) transparent conductive thin film on the passivation layer 114 by magnetron sputtering, and then forming a pattern including a common electrode 108 and its connection part 15 by using a seventh patterning process (i.e., after coating photo resist, exposing and developing, performing etching and peeling). The first via 401 is filled with a transparent conductive material for forming the common electrode 108. The common electrode 108 may be electrically connected to the common electrode line 201 through the first via 401.

Through above steps, the array substrate provided in the second embodiment of the invention, the structure of which is as shown in FIG.12, may be manufactured. It should be noted that, above steps may be performed in an order as illustrated above, however, they may be performed in other different order.

In summary, in the array substrate in the embodiments of the invention, a common electrode line is provided between the buffer layer and the base substrate, so that the common electrode line and the pixel electrode thereabove together form a storage capacitor, thus the storage capacitance is increased. Also, as the common electrode line is provided in the same layer as the data lines and the light blocking metal layer, thereby the common electrode line, the data lines and the light blocking metal layer may be formed by a single exposure process, therefore, the manufacturing procedure is reduced, and the manufacturing process is simplified, while the manufacturing cost is reduced and the manufacturing time is shortened.

## Claims

1. An array substrate comprising a base substrate (101) and data lines (107) and scan lines (110) provided on the base substrate (101), the data lines (107) and the scan lines (110) define pixel regions, each of the pixel regions is provided with a thin film transistor, a pixel electrode (109), a common electrode (108) and a common electrode line (201) thereinside, the thin film transistor comprises a gate electrode (106), a source electrode (105), a drain electrode (104) and an active layer (103), and the source electrode (105) and the drain electrode (104) are provided on opposite sides of the active layer (103) respectively, wherein
the data line (107) and the common electrode line (201) are provided in the same layer on the base substrate (101) and below the active layer (103), the data line (107) and the common electrode line (201) are provided separately, the common electrode (108) is provided with a connection part (115) which at least partly overlaps with the common electrode line (201) in an orthographic projection direction, and the common electrode (108) is electrically connected to the common electrode line (201) through a first via (401) between the connection part (115) and the common electrode line (201), **characterized in that**
the gate electrode (106) is provided above the active layer (103), the pixel electrode (109) is provided above the gate electrode (106), and
the common electrode line (201) is formed below the drain electrode (104).

2. The array substrate according to claim 1, wherein the data line (107) is made of the same conductive material as the common electrode line (201).

3. The array substrate according to claim 1, wherein the active layer (103) is made of a low temperature poly-silicon material, the source electrode (105) and the drain electrode (104) are formed on the opposite sides of the active layer (103) by ion implantation.

4. The array substrate according to claim 3, further comprising a buffer layer (102) which is provided below the active layer (103) and above the base substrate (101), and covers the data line (107) and the common electrode line (201).

5. The array substrate according to claim 4, further comprising a gate insulating layer (111) provided above the active layer (103) and below the gate electrode (106).

6. The array substrate according to claim 5, further comprising an intermediate dielectric layer (112) provided above the gate electrode (106).

7. The array substrate according to claim 6, wherein a second via (402) is provided in positions of the buffer layer (102), the gate insulating layer (111) and the intermediate dielectric layer (112) corresponding to the data line (107), a third via (403) is provided in positions of the gate insulating layer (111) and the intermediate dielectric layer (112) corresponding to the source electrode (105), and the data line (107) is electrically connected to the source electrode (105) through the second via (402) and the third via (403).

8. The array substrate according to claim 7, wherein the pixel electrode (109) is provided on the intermediate dielectric layer (112) and a passivation layer (114) provided between the pixel electrode (109) and the common electrode (108), the pixel electrode (109) partly overlaps with the common electrode (108) in the orthographic projection direction; and
the common electrode (108) is provided above the passivation layer (114), the pixel electrode (109) is provided below the passivation layer (114), a forth via (404) is provided in positions of the gate insulating layer (111) and the intermediate dielectric layer (112) corresponding to the drain electrode (104), the pixel electrode (109 is electrically connected to the drain electrode (104) through the forth via (404), the common electrode (108) is slit-shaped, the pixel electrode (109) is plate-shaped or slit-shaped, and the first via (401) between the connection part (115) and the common electrode line (201) penetrates through the buffer layer (102), the gate insulating layer (111), the intermediate dielectric layer (112) and the passivation layer (114); or the common electrode (108) is provided below the passivation layer (114), the pixel electrode (109) is provided above the passivation layer (114), a forth via (404) is provided in positions of the gate insulating layer (111) and the intermediate dielectric layer (112) corresponding to the drain electrode (104), a fifth via (405) is provided in a position of the passivation layer (114) corresponding to the drain electrode (104), the pixel electrode (109) is electrically connected to the drain electrode (104) through the forth via (404) and the fifth via (405), the common electrode (108) is plate-shaped or slit-shaped, the pixel electrode (109) is slit-shaped, and the first via (401) between the connection part (115) and the common electrode line (108) penetrates through the buffer layer (102), the gate insulating layer (111), the intermediate dielectric layer (112).

9. The array substrate according to claim 6, further comprising a light blocking metal layer (116) which is provided in the same layer as the data line (107) and the common electrode line (201) on the base substrate (101), and is provided below the active layer (103) and at least partly overlaps with the active layer (103) in the orthographic projection direction.

10. The array substrate according to claim 9, wherein the light blocking metal layer (116) is provided between regions corresponding to the source electrode (105) and the drain electrode (104), and at least partly overlaps with the gate electrode (106) in the orthographic projection direction.

11. The array substrate according to claim 1, wherein the active layer (103) is provided with lightly doped drain electrodes, which are provided between the source electrode (105) and the drain electrode (104) and at opposite sides of a region corresponding to the gate electrode (106).

12. A display device comprising the array substrate according to any one of claims 1-11.

13. A manufacturing method of an array substrate, comprising a step of forming data lines (107) and common electrode lines (201), a step of forming scan lines (110), a step of forming common electrodes (108), and a step of forming thin film transistors, the step of forming a thin film transistor comprises a step of forming a gate electrode (106), a source electrode (105), a drain electrode (106) and an active layer (103), and each of pixel regions defined by the scan lines (110) and the data lines (107) has a common electrode (108), a common electrode line (201), a pixel electrode (109) and a thin film transistor, wherein
the data line (107) and the common electrode line (108) are provided in the same layer on the base substrate (101) and below the active layer (103), the common electrode (108) is provided with a connection part (115) which at least partly overlaps with the common electrode line (201) in an orthographic projection direction, the common electrode (108) is electrically connected to the common electrode line (201) through a first via (401) between the connection part (115) and the common electrode line (201), **characterized in that**
the pixel electrode (109) is provided above the gate electrode (106), and
the common electrode line (201) is formed below the drain electrode (104).

14. The manufacturing method of an array substrate according to claim 13, specifically comprising:
forming a pattern containing the data line (107) and the common electrode line (201), which are provided separately, on the base substrate (101) by using a patterning process;
forming a buffer layer (102) and a pattern containing the active layer (103), wherein the buffer layer (102) covers the data line (107) and the common electrode line (201), and the pattern containing the active layer (103) is formed on the buffer layer (102);
forming a gate insulating layer (111) and a pattern containing the gate electrode (111); and
forming a pattern containing the source electrode (105) and the drain electrode (104), wherein the source electrode (105) and the drain electrode (104) are formed on opposite sides of the active layer (103) by ion implantation.

15. The manufacturing method of an array substrate according to claim 14, further comprising following steps of forming the common electrode (108), the connection part (115) and the pixel electrode (109):
forming an intermediate dielectric layer (112) and a pattern containing the first via (401), a second via (402), a third via (403) and a forth via (404), wherein the first via (401) is formed between the connection part (115) and the common electrode line (201) and penetrates through the buffer layer (102), the gate insulating layer (111) and the intermediate dielectric layer (112), the second via (402) is formed in a position corresponding to the data line (107) and penetrates through the buffer layer (102), the gate insulating layer (111) and the intermediate dielectric layer (112), the third via (403) is formed in a position corresponding to the source electrode (105) and penetrates through the gate insulating layer (111) and the intermediate dielectric layer (112), and the forth via (404) is formed in a position corresponding to the drain electrode (104) and penetrates through the gate insulating (111) and the intermediate dielectric layer (112);
forming a pattern containing the common electrode (108) and the connection part (115), wherein the first via (401), the second via (402), the third via (403) and the forth via (404) are filled with a conductive material used for forming the common electrode (108), the connection part (115) is electrically connected to the common electrode line (201) through the first via (401), and the data line (107) is electrically connected to the source electrode (105) through the second via (402) and the third via (403);
forming a passivation layer (114) and forming a pattern containing a fifth via (405) in the passivation layer (114), wherein the fifth via (405) is formed in a position corresponding to the drain electrode (104), and the position of the fifth via (405) corresponds to that of the forth via (405); and
forming a pattern containing the pixel electrode (109), wherein the fifth via (405) is filled with a conductive material used for forming the pixel electrode (109), and the pixel electrode (109) is electrically connected to the drain electrode (104) through the forth via (404) and the fifth via (405).

16. The manufacturing method of an array substrate according to claim 14, further comprising following steps of forming the common electrode (108), the connection part (115) and the pixel electrode (109):
forming an intermediate dielectric layer (112) and a pattern containing a second via (402), a third via (403) and a forth via (404), wherein the second via (402) is formed in a position corresponding to the data line (107) and penetrates through the buffer layer (102), the gate insulating layer (111) and the intermediate dielectric layer (112), the third via (403) is formed in a position corresponding to the source electrode (105) and penetrates through the gate insulating layer (111) and the intermediate dielectric layer (112), and the forth via (404) is formed in a position corresponding to the drain electrode (105) and penetrates through the gate insulating layer (111) and the intermediate dielectric layer (112);
forming a pattern containing the pixel electrode (109), wherein the second via (402), the third via (403) and the forth via (404) are filled with a conductive material used for forming the common electrode (108), the data line (107) is electrically connected to the source electrode (105) through the second via (402) and the third via (403), and the pixel electrode (109) is electrically connected to the drain electrode (104) through the forth via (404);
forming a passivation layer (114) and a pattern containing the common electrode (108) and the connection part (115), wherein the passivation layer (114) covers the pixel electrode (109), the pattern containing the common electrode (108) and the connection part (115) is formed above the passivation layer (114); and
forming the first via (401) between the connection part (115) and the common electrode line (201), wherein the first via (401) penetrates through the buffer layer 102), the gate insulating layer (111), the intermediate dielectric layer (112) and the passivation layer (114).

17. The manufacturing method of an array substrate according to any one of claims 14-16, the step of forming the source electrode (105) and the drain electrode (104) comprises forming lightly doped drain electrodes in the active layer (103) by ion implantation, wherein the lightly doped drain electrodes are formed between the source electrode (105) and the drain electrode (104) and on opposite sides of a region corresponding to the gate electrode (106).

18. The manufacturing method of an array substrate according to any one of claims 14-16, wherein the step of forming a pattern containing the data line (107) and the common electrode line (201) comprises: forming a light blocking metal layer (116) on the base substrate (101) so that the light blocking metal layer (116) is provided in the same layer as the data line (107) and the common electrode line (201), is provided below the active layer (103) and at least partly overlaps with the active layer (103) in the orthographic projection direction.

19. The manufacturing method of an array substrate according to claim 18, wherein at least one light blocking metal layer (116) is formed in the step of forming a pattern containing the data line (107) and the common electrode line (201), at least one gate electrode (106) is formed in the step of forming the gate insulating layer (111) and a pattern containing the gate electrode (106), and the light blocking metal layer (116) is formed in a position corresponding to that of the gate electrode (106).

## Patentansprüche

1. Arraysubstrat umfassend ein Basissubstrat (101) und Datenleitungen (107) und Abtastleitungen (110), die auf dem Basissubstrat (101) bereitgestellt sind, wobei die Datenleitungen (107) und die Abtastleitungen (110) Pixelbereiche definieren, wobei jeder der Pixelbereiche mit einem Dünnschichttransistor, einer Pixelelektrode (109), einer gemeinsamen Elektrode (108) und einer gemeinsamen Elektrodenleitung (201) darin versehen ist, wobei der Dünnschichttransistor eine Gate-Elektrode (106), eine Source-Elektrode (105), eine Drain-Elektrode (104) und eine aktive Schicht (103) umfasst, und die Source-Elektrode (105) und die Drain-Elektrode (104) jeweils auf gegenüberliegenden Seiten der aktiven Schicht (103) bereitgestellt sind, wobei
die Datenleitung (107) und die gemeinsame Elektrodenleitung (201) in derselben Schicht auf dem Basissubstrat (101) und unterhalb der aktiven Schicht (103) bereitgestellt sind, die Datenleitung (107) und die gemeinsame Elektrodenleitung (201) separat bereitgestellt sind, die gemeinsame Elektrode (108) mit einem Verbindungsteil (115) versehen ist, welcher sich mindestens teilweise mit der gemeinsamen Elektrodenleitung (201) in einer orthografischen Vorsprungsrichtung überlappt, und die gemeinsame Elektrode (108) elektrisch mit der gemeinsamen Elektrodenleitung (201) durch eine erste Durchkontaktierung (401) zwischen dem Verbindungsteil (115) und der gemeinsamen Elektrodenleitung (201) verbunden ist, **dadurch gekennzeichnet, dass**
die Gate-Elektrode (106) oberhalb der aktiven Schicht (103) bereitgestellt ist, die Pixel-Elektrode (109) oberhalb der Gate-Elektrode (106) bereitgestellt ist, und
die gemeinsame Elektrodenleitung (201) unterhalb der Drain-Elektrode (104) bereitgestellt ist.

2. Arraysubstrat nach Anspruch 1, wobei die Datenleitung (107) aus demselben leitfähigen Material wie die gemeinsame Elektrodenleitung (201) hergestellt ist.

3. Arraysubstrat nach Anspruch 1, wobei die aktive Schicht (103) aus einem Poly-Silizium-Material mit geringer Temperatur hergestellt ist, die Source-Elektrode (105) und die Drain-Elektrode (104) auf den gegenüberliegenden Seiten der aktiven Schicht (103) durch Ionenimplantation gebildet sind.

4. Arraysubstrat nach Anspruch 3, ferner umfassend eine Pufferschicht (102), welche unterhalb der aktiven Schicht (103) und oberhalb des Basissubstrats (101) bereitgestellt ist und die Datenleitung (107) und die gemeinsame Elektrodenleitung (201) abdeckt.

5. Arraysubstrat nach Anspruch 4, ferner umfassend eine Gate-Isolierungsschicht (111), die oberhalb der aktiven Schicht (103) und unterhalb der Gate-Elektrode (106) bereitgestellt ist.

6. Arraysubstrat nach Anspruch 5, ferner umfassend eine dielektrische Zwischenschicht (112), die oberhalb der Gate-Elektrode (106) bereitgestellt ist.

7. Arraysubstrat nach Anspruch 6, wobei eine zweite Durchkontaktierung (402) in Positionen der Pufferschicht (102), der Gate-Isolierungsschicht (111) und der dielektrischen Zwischenschicht (112) entsprechend der Datenleitung (107) bereitgestellt ist, eine dritte Durchkontaktierung (403) in Positionen der Gate-Isolierungsschicht (111) und der dielektrischen Zwischenschicht (112) entsprechend der Source-Elektrode (105) bereitgestellt ist, und die Datenleitung (107) elektrisch mit der Source-Elektrode (105) durch die zweite Durchkontaktierung (402) und die dritte Durchkontaktierung (403) verbunden ist.

8. Arraysubstrat nach Anspruch 7, wobei die Pixelelektrode (109) auf der dielektrischen Zwischenschicht (112) und einer Passivierungsschicht (114), die zwischen der Pixelelektrode (109) und der gemeinsamen Elektrode (108) bereitgestellt ist, bereitgestellt ist, wobei sich die Pixelelektrode (109) teilweise mit der gemeinsamen Elektrode (108) in der orthografischen Vorsprungsrichtung überlappt; und
die gemeinsame Elektrode (108) oberhalb der Passivierungsschicht (114) bereitgestellt ist, die Pixelelektrode (109) unterhalb der Passivierungsschicht (114) bereitgestellt ist, eine vierte Durchkontaktierung (404) in Positionen der Gate-Isolierungsschicht (111) und der dielektrischen Zwischenschicht (112) entsprechend der Drain-Elektrode (104) bereitgestellt ist, die Pixelelektrode (109) elektrisch mit der Drain-Elektrode (104) durch die vierte Durchkontaktierung (404) verbunden ist, die gemeinsame Elektrode (108) schlitzförmig ist, die Pixel-Elektrode (109) plattenförmig oder schlitzförmig ist, und die erste Durchkontaktierung (401) zwischen dem Verbindungsteil (115) und der gemeinsamen Elektrodenleitung (201) die Pufferschicht (102), die Gate-Isolierungsschicht (111), die dielektrische Zwischenschicht (112) und die Passivierungsschicht (114) durchdringt; oder die gemeinsame Elektrode (108) unterhalb der Passivierungsschicht (114) bereitgestellt ist, die Pixelelektrode (109) oberhalb der Passivierungsschicht (114) bereitgestellt ist, eine vierte Durchkontaktierung (404) in Positionen der Gate-Isolierungsschicht (111) und der dielektrischen Zwischenschicht (112) entsprechend der Drain-Elektrode (104) bereitgestellt ist, eine fünfte Durchkontaktierung (405) in einer Position der Passivierungsschicht (114) entsprechend der Drain-Elektrode (104) bereitgestellt ist, die Pixelelektrode (109) elektrisch mit der Drain-Elektrode (104) durch die vierte Durchkontaktierung (404) und die fünfte Durchkontaktierung (405) verbunden ist, die gemeinsame Elektrode (108) plattenförmig oder schlitzförmig ist, die Pixelelektrode (109) schlitzförmig ist, und die erste Durchkontaktierung (401) zwischen dem Verbindungsteil (115) und der gemeinsamen Elektrodenleitung (108) die Pufferschicht (102), die Gate-Isolierungsschicht (111), die dielektrische Zwischenschicht (112) durchdringt.

9. Arraysubstrat nach Anspruch 6, ferner umfassend eine lichtblockierende Metallschicht (116), welche in derselben Schicht wie die Datenleitung (107) und die gemeinsame Elektrodenleitung (201) auf dem Basissubstrat (101) bereitgestellt ist und unterhalb der aktiven Schicht (103) bereitgestellt ist und sich mindestens teilweise mit der aktiven Schicht (103) in der orthografischen Vorsprungsrichtung überlappt.

10. Arraysubstrat nach Anspruch 9, wobei die lichtblockierende Metallschicht (116) zwischen Bereichen entsprechend der Source-Elektrode (105) und der Drain-Elektrode (104) bereitgestellt ist und sich mindestens teilweise mit der Gate-Elektrode (106) in der orthografischen Vorsprungsrichtung überlappt.

11. Arraysubstrat nach Anspruch 1, wobei die aktive Schicht (103) mit leicht dotierten Drain-Elektroden versehen ist, welche zwischen der Source-Elektrode (105) und der Drain-Elektrode (104) und auf gegenüberliegenden Seiten eines Bereichs entsprechend der Gate-Elektrode (106) bereitgestellt sind.

12. Anzeigevorrichtung umfassend das Arraysubstrat nach einem der Ansprüche 1-11.

13. Herstellungsverfahren eines Arraysubstrats, umfassend einen Schritt des Bildens von Datenleitungen (107) und gemeinsamen Elektrodenleitungen (201), einen Schritt des Bildens von Abtastleitungen (110), einen Schritt des Bildens von gemeinsamen Elektroden (108) und einen Schritt des Bildens von Dünnschichttransistoren, wobei der Schritt des Bildens eines Dünnschichttransistors einen Schritt des Bildens einer Gate-Elektrode (106), einer Source-Elektrode (105), einer Drain-Elektrode (106) und einer aktiven Schicht (103) umfasst, und jeder der Pixelbereiche, die durch die Abtastleitungen (110) und die Datenleitungen (107) definiert sind, eine gemeinsame Elektrode (108), eine gemeinsame Elektrodenleitung (201), eine Pixelelektrode (109) und einen Dünnschichttransistor aufweist, wobei
die Datenleitung (107) und die gemeinsame Elektrodenleitung (108) in derselben Schicht auf dem Basissubstrat (101) und unterhalb der aktiven Schicht (103) bereitgestellt werden, die gemeinsame Elektrode (108) mit einem Verbindungsteil (115) versehen ist, welcher sich mindestens teilweise mit der gemeinsamen Elektrodenleitung (201) in einer orthografischen Vorsprungsrichtung überlappt, die gemeinsame Elektrode (108) elektrisch mit der gemeinsamen Elektrodenleitung (201) durch eine erste Durchkontaktierung (401) zwischen dem Verbindungsteil (115) und der gemeinsamen Elektrodenleitung (201) verbunden ist, **dadurch gekennzeichnet, dass**
die Pixelelektrode (109) oberhalb der Gate-Elektrode (106) bereitgestellt wird, und
die gemeinsame Elektrodenleitung (201) unterhalb der Drain-Elektrode (104) gebildet wird.

14. Herstellungsverfahren eines Arraysubstrats nach Anspruch 13, das insbesondere Folgendes umfasst:
Bilden eines Musters, das die Datenleitung (107) und die gemeinsame Elektrodenleitung (201) enthält, welche getrennt bereitgestellt werden, auf dem Basissubstrat (101) durch Verwenden eines Strukturierungsprozesses;
Bilden einer Pufferschicht (102) und eines Musters, das die aktive Schicht (103) enthält, wobei die Pufferschicht (102) die Datenleitung (107) und die gemeinsame Elektrodenleitung (201) abdeckt, und das Muster, das die aktive Schicht (103) enthält, auf der Pufferschicht (102) gebildet wird;
Bilden einer Gate-Isolierungsschicht (111) und eines Musters, das die Gate-Elektrode (111) enthält; und
Bilden eines Musters, das die Source-Elektrode (105) und die Drain-Elektrode (104) enthält, wobei die Source-Elektrode (105) und die Drain-Elektrode (104) auf gegenüberliegenden Seiten der aktiven Schicht (103) durch Ionenimplantation gebildet werden.

15. Herstellungsverfahren eines Arraysubstrats nach Anspruch 14, ferner umfassend folgende Schritte des Bildens der gemeinsamen Elektrode (108), des Verbindungsteils (115) und der Pixelelektrode (109):
Bilden einer dielektrischen Zwischenschicht (112) und eines Musters, das die erste Durchkontaktierung (401), eine zweite Durchkontaktierung (402), eine dritte Durchkontaktierung (403) und eine vierte Durchkontaktierung (404) enthält, wobei die erste Durchkontaktierung (401) zwischen dem Verbindungsteil (115) und der gemeinsamen Elektrodenleitung (201) gebildet wird und die Pufferschicht (102), die Gate-Isolierungsschicht (111) und die dielektrische Zwischenschicht (112) durchdringt, die zweite Durchkontaktierung (402) in einer Position entsprechend der Datenleitung (107) gebildet wird und die Pufferschicht (102), die Gate-Isolierungsschicht (111) und die dielektrische Zwischenschicht (112) durchdringt, die dritte Durchkontaktierung (403) in einer Position entsprechend der Source-Elektrode (105) gebildet wird und die Gate-Isolierungsschicht (111) und die dielektrische Zwischenschicht (112) durchdringt, und die vierte Durchkontaktierung (404) in einer Position entsprechend der Drain-Elektrode (104) gebildet wird und die Gate-Isolierung (111) und die dielektrische Zwischenschicht (112) durchdringt;
Bilden eines Musters, das die gemeinsame Elektrode (108) und den Verbindungsteil (115) enthält, wobei die erste Durchkontaktierung (401), die zweite Durchkontaktierung (402), die dritte Durchkontaktierung (403) und die vierte Durchkontaktierung (404) mit einem leitfähigen Material gefüllt sind, das zum Bilden der gemeinsamen Elektrode (108) verwendet wird, der Verbindungsteil (115) elektrisch mit der gemeinsamen Elektrodenleitung (201) durch die erste Durchkontaktierung (401) verbunden ist, und die Datenleitung (107) elektrisch mit der Source-Elektrode (105) durch die zweite Durchkontaktierung (402) und die dritte Durchkontaktierung (403) verbunden ist;
Bilden einer Passivierungsschicht (114) und Bilden eines Musters, das eine fünfte Durchkontaktierung (405) in der Passivierungsschicht (114) enthält, wobei die fünfte Durchkontaktierung (405) in einer Position entsprechend der Drain-Elektrode (104) gebildet wird, und die Position der fünften Durchkontaktierung (405) jener der vierten Durchkontaktierung (405) entspricht; und
Bilden eines Musters, das die Pixelelektrode (109) enthält, wobei die fünfte Durchkontaktierung (405) mit einem leitfähigen Material gefüllt ist, das zum Bilden der Pixelelektrode (109) verwendet wird, und die Pixelelektrode (109) elektrisch mit der Drain-Elektrode (104) durch die vierte Durchkontaktierung (404) und die fünfte Durchkontaktierung (405) verbunden ist.

16. Herstellungsverfahren eines Arraysubstrats nach Anspruch 14, ferner umfassend folgende Schritte des Bildens der gemeinsamen Elektrode (108), des Verbindungsteils (115) und der Pixelelektrode (109):
Bilden einer dielektrischen Zwischenschicht (112) und eines Musters, das eine zweite Durchkontaktierung (402), eine dritte Durchkontaktierung (403) und eine vierte Durchkontaktierung (404) enthält, wobei die zweite Durchkontaktierung (402) in einer Position entsprechend der Datenleitung (107) gebildet wird und die Pufferschicht (102), die Gate-Isolierungsschicht (111) und die dielektrische Zwischenschicht (112) durchdringt, die dritte Durchkontaktierung (403) in einer Position entsprechend der Source-Elektrode (105) gebildet wird und die Gate-Isolierungsschicht (111) und die dielektrische Zwischenschicht (112) durchdringt, und die vierte Durchkontaktierung (404) in einer Position entsprechend der Drain-Elektrode (105) gebildet wird und die Gate-Isolierungsschicht (111) und die dielektrische Zwischenschicht (112) durchdringt;
Bilden eines Musters, das die Pixelelektrode (109) enthält, wobei die zweite Durchkontaktierung (402), die dritte Durchkontaktierung (403) und die vierte Durchkontaktierung (404) mit einem leitfähigen Material gefüllt sind, das zum Bilden der gemeinsamen Elektrode (108) verwendet wird, die Datenleitung (107) elektrisch mit der Source-Elektrode (105) durch die zweite Durchkontaktierung (402) und die dritte Durchkontaktierung (403) verbunden ist, und die Pixelelektrode (109) elektrisch mit der Drain-Elektrode (104) durch die vierte Durchkontaktierung (404) verbunden ist;
Bilden einer Passivierungsschicht (114) und eines Musters, das die gemeinsame Elektrode (108) und den Verbindungsteil (115) enthält, wobei die Passivierungsschicht (114) die Pixelelektrode (109) abdeckt, das Muster, das die gemeinsame Elektrode (108) und den Verbindungsteil (115) enthält, oberhalb der Passivierungsschicht (114) gebildet wird; und
Bilden der ersten Durchkontaktierung (401) zwischen dem Verbindungsteil (115) und der gemeinsamen Elektrodenleitung (201), wobei die erste Durchkontaktierung (401) die Pufferschicht (102), die Gate-Isolierungsschicht (111), die dielektrische Zwischenschicht (112) und die Passivierungsschicht (114) durchdringt.

17. Herstellungsverfahren eines Arraysubstrats nach einem der Ansprüche 14-16, wobei der Schritt des Bildens der Source-Elektrode (105) und der Drain-Elektrode (104) das Bilden von leicht dotierten Drain-Elektroden in der aktiven Schicht (103) durch Ionenimplantation umfasst, wobei die leicht dotierten Drain-Elektroden zwischen der Source-Elektrode (105) und der Drain-Elektrode (104) und auf gegenüberliegenden Seiten eines Bereichs entsprechend der Gate-Elektrode (106) gebildet werden.

18. Herstellungsverfahren eines Arraysubstrats nach einem der Ansprüche 14-16, wobei der Schritt des Bildens eines Musters, das die Datenleitung (107) und die gemeinsame Elektrodenleitung (201) enthält, Folgendes umfasst: Bilden einer lichtblockierenden Metallschicht (116) auf dem Basissubstrat (101), so dass die lichtblockierende Metallschicht (116) in derselben Schicht wie die Datenleitung (107) und die gemeinsame Elektrodenleitung (201) bereitgestellt wird, unterhalb der aktiven Schicht (103) bereitgestellt wird und sich mindestens teilweise mit der aktiven Schicht (103) in der orthografischen Vorsprungsrichtung überlappt.

19. Herstellungsverfahren eines Arraysubstrats nach Anspruch 18, wobei mindestens eine lichtblockierende Metallschicht (116) in dem Schritt des Bildens eines Musters, das die Datenleitung (107) und die gemeinsame Elektrodenleitung (201) enthält, gebildet wird, mindestens eine Gate-Elektrode (106) in dem Schritt des Bildens der Gate-Isolierungsschicht (111) und eines Musters, das die Gate-Elektrode (106) enthält, gebildet wird, und die lichtblockierende Metallschicht (116) in einer Position entsprechend jener der Gate-Elektrode (106) gebildet wird.

## Revendications

1. Substrat de réseau comprenant un substrat de base (101) et des lignes de données (107) et des lignes de balayage (110) prévues sur le substrat de base (101), les lignes de données (107) et les lignes de balayage (110) définissent des régions de pixels, chacune des régions de pixels est prévue avec un transistor en couche mince, une électrode de pixel (109), une électrode commune (108) et une ligne d'électrode commune (201) à l'intérieur, le transistor en couche mince comprend une électrode de grille (106), une électrode de source (105), une électrode de drain (104) et une couche active (103), et l'électrode de source (105) et l'électrode de drain (104) sont prévues respectivement sur des côtés opposés de la couche active (103), dans lequel
la ligne de données (107) et la ligne d'électrode commune (201) sont prévues dans la même couche sur le substrat de base (101) et sous la couche active (103), la ligne de données (107) et la ligne d'électrode commune (201) sont fournies séparément, l'électrode commune (108) est pourvue d'une partie de connexion (115) qui chevauche au moins partiellement la ligne d'électrode commune (201) dans une direction de projection orthographique, et l'électrode commune (108) est électriquement connectée à la ligne d'électrode commune (201) au travers d'un premier via (401) entre la partie de connexion (115) et la ligne d'électrode commune (201), **caractérisé en ce que**
l'électrode de grille (106) est prévue au-dessus de la couche active (103). l'électrode de pixel (109) est prévue au-dessus de l'électrode de grille (106), et
la ligne d'électrode commune (201) est formée au-dessous de l'électrode de drain (104).

2. Substrat de réseau selon la revendication 1, dans lequel la ligne de données (107) est réalisée dans le même matériau conducteur que la ligne d'électrode commune (201).

3. Substrat de réseau selon la revendication 1, dans lequel la couche active (103) est réalisée dans un matériau de poly-silicium à basse température, l'électrode de source (105) et l'électrode de drain (104) sont formées sur les côtés opposés de la couche active (103) par implantation ionique.

4. Substrat de réseau selon la revendication 3, comprenant en outre une couche tampon (102) qui est prévue au-dessous de la couche active (103) et au-dessus du substrat de base (101), et recouvre la ligne de données (107) et la ligne d'électrode commune (201).

5. Substrat de réseau selon la revendication 4, comprenant en outre une couche d'isolation de grille (111) prévue au-dessus de la couche active (103) et au-dessous de l'électrode de grille (106).

6. Substrat de réseau selon la revendication 5, comprenant en outre une couche diélectrique intermédiaire (112) prévue au-dessus de l'électrode de grille (106).

7. Substrat de réseau selon la revendication 6, dans lequel un deuxième via (402) est prévu dans des positions de la couche tampon (102), de la couche d'isolation de grille (111) et de la couche diélectrique intermédiaire (112) correspondant à la ligne de données (107), un troisième via (403) est prévu dans des positions de la couche d'isolation de grille (111) et de la couche diélectrique intermédiaire (112) correspondant à l'électrode de source (105), et la ligne de données (107) est connectée électriquement à l'électrode de source (105) au travers du deuxième via (402) et du troisième via (403).

8. Substrat de réseau selon la revendication 7, dans lequel l'électrode de pixel (109) est prévue sur la couche diélectrique intermédiaire (112) et une couche de passivation (114) est prévue entre l'électrode de pixel (109) et l'électrode commune (108),
l'électrode de pixel (109) chevauche partiellement l'électrode commune (108) dans la direction de projection orthographique ; et
l'électrode commune (108) est prévue au-dessus de la couche de passivation (114), l'électrode de pixel (109) est prévue au-dessous de la couche de passivation (114), un quatrième via (404) est prévu dans des positions de la couche d'isolation de grille (111) et de la couche diélectrique intermédiaire (112) correspondant à l'électrode de drain (104), l'électrode de pixel (109) est connectée électriquement à l'électrode de drain (104) au travers du quatrième via (404), l'électrode commune (108) est en forme de fente, l'électrode de pixel (109) est en forme de plaque ou en forme de fente, et le premier via (401) entre la partie de connexion (115) et la ligne d'électrode commune (201) pénètre au travers de la couche tampon (102), de la couche d'isolation de grille (111), de la couche diélectrique intermédiaire (112) et de la couche de passivation (114) ; ou l'électrode commune (108) est disposée au-dessous de la couche de passivation (114), l'électrode de pixel (109) est prévue au-dessus de la couche de passivation (114), un quatrième via (404) est prévu dans des positions de la couche d'isolation de grille (111) et de la couche diélectrique intermédiaire (112) correspondant à l'électrode de drain (104), un cinquième via (405) est prévu dans une position de la couche de passivation (114) correspondant à l'électrode de drain (104), l'électrode de pixel (109) est connectée électriquement à l'électrode de drain (104) au travers du quatrième via (404) et du cinquième via (405), l'électrode commune (108) est en forme de plaque ou en forme de fente, l'électrode de pixel (109) est en forme de fente, et le premier via (401) entre la partie de connexion (115) et la ligne d'électrode commune (108) pénètre au travers de la couche tampon (102), de la couche d'isolation de grille (111), de la couche diélectrique intermédiaire (112).

9. Substrat de réseau selon la revendication 6, comprenant en outre une couche de métal bloquant la lumière (116) qui est prévue dans la même couche que la ligne de données (107) et que la ligne d'électrode commune (201) sur le substrat de base (101), et est prévu au-dessous de la couche active (103) et chevauche au moins partiellement la couche active (103) dans la direction de projection orthographique.

10. Substrat de réseau selon la revendication 9, dans lequel la couche de métal bloquant la lumière (116) est prévue entre des régions correspondant à l'électrode de source (105) et à l'électrode de drain (104), et chevauche au moins partiellement l'électrode de grille (106) dans la direction de la projection orthographique.

11. Substrat de réseau selon la revendication 1, dans lequel la couche active (103) est munie d'électrodes de drain légèrement dopées, qui sont prévues entre l'électrode de source (105) et l'électrode de drain (104) et sur des côtés opposés d'une région correspondante à l'électrode de grille (106).

12. Dispositif d'affichage comprenant le substrat de réseau selon l'une quelconque des revendications 1 à 11.

13. Procédé de fabrication d'un substrat de réseau, comprenant une étape de formation de lignes de données (107) et de lignes d'électrodes communes (201), une étape de formation de lignes de balayage (110), une étape de formation d'électrodes communes (108), et une étape de formation de transistors en couche mince, l'étape de formation d'un transistor en couche mince comprend une étape de formation d'une électrode de grille (106), d'une électrode de source (105), d'une électrode de drain (106) et d'une couche active (103), et chacune des régions de pixels définies par les lignes de balayage (110) et les lignes de données (107) a une électrode commune (108), une ligne d'électrode commune (201), une électrode de pixel (109) et un transistor en couche mince, dans lequel
la ligne de données (107) et la ligne d'électrode commune (108) sont prévues dans la même couche sur le substrat de base (101) et au-dessous de la couche active (103), l'électrode commune (108) est munie d'une partie de connexion (115) qui chevauche au moins partiellement la ligne d'électrode commune (201) dans une direction de projection orthographique, l'électrode commune (108) est connectée électriquement à la ligne d'électrode commune (201) au travers d'un premier via (401) entre la partie de connexion (115) et la ligne d'électrode commune (201), **caractérisé en ce que**
l'électrode de pixel (109) est prévue au-dessus de l'électrode de grille (106), et
la ligne d'électrode commune (201) est formée au-dessous de l'électrode de drain (104).

14. Procédé de fabrication d'un substrat de réseau selon la revendication 13, comprenant en particulier les étapes consistant à :
former une structure contenant la ligne de données (107) et la ligne d'électrode commune (201), qui sont fournis séparément, sur le substrat de base (101) en utilisant un processus de structuration ;
former une couche tampon (102) et une structure contenant la couche active (103), dans lequel la couche tampon (102) recouvre la ligne de données (107) et la ligne d'électrode commune (201), et la structure contenant la couche active (103) est formée sur la couche tampon (102) ;
former une couche d'isolation de grille (111) et une structure contenant l'électrode de grille (111) ; et
former une structure contenant l'électrode de source (105) et l'électrode de drain (104), dans lequel l'électrode de source (105) et l'électrode de drain (104) sont formées sur des côtés opposés de la couche active (103) par implantation ionique.

15. Procédé de fabrication d'un substrat de réseau selon la revendication 14, comprenant en outre les étapes suivantes consistant à former l'électrode commune (108), la partie de connexion (115) et l'électrode de pixel (109) :
former une couche diélectrique intermédiaire (112) et une structure contenant le premier via (401), un deuxième via (402), un troisième via (403) et un quatrième via (404), dans lequel le premier via (401) est formé entre la partie de connexion (115) et la ligne d'électrode commune (201) et pénètre au travers de la couche tampon (102), de la couche d'isolation de grille (111) et de la couche diélectrique intermédiaire (112), le deuxième via (402) est formé dans une position correspondant à la ligne de données (107) et pénètre au travers de la couche tampon (102), de la couche d'isolation de grille (111) et de la couche diélectrique intermédiaire (112), le troisième via (403) est formé dans une position correspondant à l'électrode de source (105) et pénètre au travers de la couche d'isolation de grille (111) et de la couche diélectrique intermédiaire (112), et le quatrième via (404) est formé dans une position correspondant à l'électrode de drain (104) et pénètre au travers de la grille d'isolation (111) et de la couche diélectrique intermédiaire (112) ;
former une structure contenant l'électrode commune (108) et la partie de connexion (115), dans lequel le premier via (401), le deuxième via (402), le troisième via (403) et le quatrième via (404) sont remplis d'un matériau conducteur utilisé pour former l'électrode commune (108), la partie de connexion (115) est électriquement connectée à la ligne d'électrode commune (201) au travers du premier via (401), et la ligne de données (107) est connectée électriquement à l'électrode de source (105) au travers du deuxième via (402) et du troisième via (403) ;
former une couche de passivation (114) et former une structure contenant un cinquième via (405) dans la couche de passivation (114), dans lequel le cinquième via (405) est formé dans une position correspondant à l'électrode de drain (104), et la position du cinquième via (405) correspond à celle du quatrième via (405) ; et
former une structure contenant l'électrode de pixel (109), dans lequel le cinquième via (405) est rempli d'un matériau conducteur utilisé pour former l'électrode de pixel (109), et l'électrode de pixel (109) est électriquement connectée à l'électrode de drain (104) au travers du quatrième via (404) et du cinquième via (405).

16. Procédé de fabrication d'un substrat de réseau selon la revendication 14, comprenant en outre les étapes suivantes consistant à former l'électrode commune (108), la partie de connexion (115) et l'électrode de pixel (109) :
former une couche diélectrique intermédiaire (112) et une structure contenant un deuxième via (402), un troisième via (403) et un quatrième via (404), dans lequel le deuxième via (402) est formé dans une position correspondant à la ligne de données (107) et pénètre au travers de la couche tampon (102), de la couche d'isolation de grille (111) et de la couche diélectrique intermédiaire (112), le troisième via (403) est formé dans une position correspondant à l'électrode de source (105) et pénètre au travers de la couche d'isolation de grille (111) et de la couche diélectrique intermédiaire (112), et le quatrième via (404) est formé dans une position correspondant à l'électrode de drain (105) et pénètre au travers de la couche d'isolation de grille (111) et de la couche diélectrique intermédiaire (112) ;
former une structure contenant l'électrode de pixel (109), dans lequel le deuxième via (402), le troisième via (403) et le quatrième via (404) sont remplis d'un matériau conducteur utilisé pour former l'électrode commune (108), la ligne de données (107) est connectée électriquement à l'électrode de source (105) au travers du deuxième via (402) et du troisième via (403), et l'électrode de pixel (109) est connectée électriquement à l'électrode de drain (104) au travers du quatrième via (404) ;
former une couche de passivation (114) et une structure contenant l'électrode commune (108) et la partie de connexion (115), dans lequel la couche de passivation (114) recouvre l'électrode de pixel (109), la structure contenant l'électrode commune (108) et la partie de connexion (115) est formée au-dessus de la couche de passivation (114), et
former le premier via (401) entre la partie de connexion (115) et la ligne d'électrode commune (201), dans lequel le premier via (401) pénètre au travers de la couche tampon (102), de la couche d'isolation de grille (111), de la couche diélectrique intermédiaire (112) et de la couche de passivation (114).

17. Procédé de fabrication d'un substrat de réseau selon l'une quelconque des revendications 14 à 16, dans lequel l'étape de formation de l'électrode de source (105) et de l'électrode de drain (104) comprend la formation d'électrodes de drain légèrement dopées dans la couche active (103) par implantation ionique, dans lequel les électrodes de drain légèrement dopées sont formées entre l'électrode de source (105) et l'électrode de drain (104) et sur des côtés opposés d'une région correspondant à l'électrode de grille (106).

18. Procédé de fabrication d'un substrat de réseau selon l'une quelconque des revendications 14 à 16, dans lequel l'étape de formation d'une structure contenant la ligne de données (107) et la ligne d'électrode commune (201) comprend : la formation d'une couche de métal bloquant la lumière (116) sur le substrat de base (101) de sorte que la couche de métal bloquant la lumière (116) est prévue dans la même couche que la ligne de données (107) et que la ligne d'électrode commune (201), est disposée sous la couche active (103) et chevauche au moins partiellement la couche active (103) dans la direction de protection orthographique.

19. Procédé de fabrication d'un substrat de réseau selon la revendication 18, dans lequel au moins une couche de métal bloquant la lumière (116) est formée dans l'étape de formation d'une structure contenant la ligne de données (107) et la ligne d'électrode commune (201), au moins une électrode de grille (106) est formée dans l'étape de formation de la couche d'isolation de grille (111) et une structure contenant l'électrode de grille (106), et la couche de métal bloquant la lumière (116) est formée dans une position correspondant à celle de l'électrode de grille (106).
